# EUROPEAN PATENT SPECIFICATION

(11) **EP 3 013 021 B1**
(45) Date of publication and mention of the grant of the patent: **19.09.2018**
(21) Application number: 15169742.2
(22) Date of filing: 28.05.2015
(51) Int. Cl.: H04M 1/02, B29C 45/14

(54) **HOUSING, ELECTRONIC DEVICE USING SAME, AND METHOD FOR MAKING SAME**
GEHÄUSE, ELEKTRONISCHE VORRICHTUNG DAMIT UND VERFAHREN ZUR HERSTELLUNG DAVON
BOITIER, DISPOSITIF ELECTRONIQUE UTILISANT CELUI-CI ET SON PROCEDE DE FABRICATION

(30) Priority: 23.10.2014 CN 201410570109
(43) Date of publication of application: 27.04.2016
(73) Proprietor: Shenzhen Futaihong Precision Industry Co., Ltd., Shenzhen City, Guangdong Province 518109 (CN); FIH (Hong Kong) Limited, Hong Kong (HK)
(72) Inventor: OU, Wu-Zheng, 518109 ShenZhen City (CN); GU, Chang-Hai, 518109 ShenZhen City (CN); WANG, Dan, 518109 ShenZhen City (CN); LIU, Xiao-Kai, 518109 ShenZhen City (CN)
(74) Representative: CMS Cameron McKenna Nabarro Olswang LLP

(56) References cited:
- EP-A1- 2 670 116
- EP-A2- 2 764 975
- EP-A2- 2 778 830

## Description

### FIELD

The subject matter herein generally relates to a housing, an electronic device using the housing, and a method for making the housing.

### BACKGROUND

Metal housings are widely used for electronic devices.

EP 2764975A2 discloses an electronic device (100) including a plurality of electronic parts; one or more housing components (210,220) forming a space for receiving the plurality of electronic parts; and a cover (230) detachable from the one or more housing components (210,220), the cover (230) including a first member (231) having a plurality of metal elements (5311) suspended in a nonmetal base (5320) and a second member (232) coupled to the first member (231).

EP 2670116A1 provided are a cover having a metallic grid structure and a method for manufacturing the cover. The cover (100) includes a pattern portion (110) formed of a metallic material, in which a plurality of patterns (111) are independently disposed spaced apart from each other and an injection portion (120) disposed between pattern portions to connect the pattern portions, the injection portion (120) being formed of a non-metallic material. The method includes forming a pre-pattern portion (105) including patterns (111) in a regular or irregular form and a bridge (112) connecting the patterns on a metallic plate (101), forming the injection portion (120) on the pre-pattern portion (105) by insert-injection or thermo-compression press, and removing the bridge (112).

### SUMMARY

According to a first aspect of the disclosure, a housing is provided, as defined in appended claim 1.

According to a second aspect of the disclosure, a method of making a housing is provided, as defined in appended claim 9.

According to a third aspect of the disclosure, an electronic device is provided. The electronic device comprises a main body, a housing in accordance with the first aspect of the disclosure, the housing being mounted on the main body, and an antenna assembled in the housing.

### BRIEF DESCRIPTION OF THE FIGURES

Implementations of the present technology will now be described, by way of example only, with reference to the attached figures.
FIG. 1 is an isometric view of an electronic device, according to an exemplary embodiment.
FIG. 2 is a partial, isometric view of a housing of the electronic device shown in FIG. 1.
FIG. 3 is similar to FIG. 2, but shown from another angle.
FIG. 4 is an exploded, isometric view of the housing shown in FIG. 1.
FIG. 5 is a cross-sectional view of the housing along line V-V of FIG. 2.
FIG. 6 is an enlarged view of the housing of circled portion VI in FIG. 5.
FIG. 7 is an isometric view of metal strips during the process of making the housing of FIG. 2
FIG. 8 is an isometric view of the metal strips of FIG. 7 with notches.
FIG. 9 is an isometric view of a metal strip assembly during the process of making the housing of FIG. 2

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiments described herein can be practiced without these specific details. In other instances, methods, procedures and components have not been described in detail so as not to obscure the related relevant feature being described. Also, the description is not to be considered as limiting the scope of the embodiments described herein. The drawings are not necessarily to scale and the proportions of certain parts may be exaggerated to better illustrate details and features of the present disclosure.

The term "comprising" when utilized, means "including, but not necessarily limited to"; it specifically indicates open-ended inclusion or membership in the so-described combination, group, series and the like. The term "coupled" when utilized, means "either a direct electrical connection between the things that are connected, or an indirect connection through one or more passive or active intermediary devices, but not necessarily limited to".

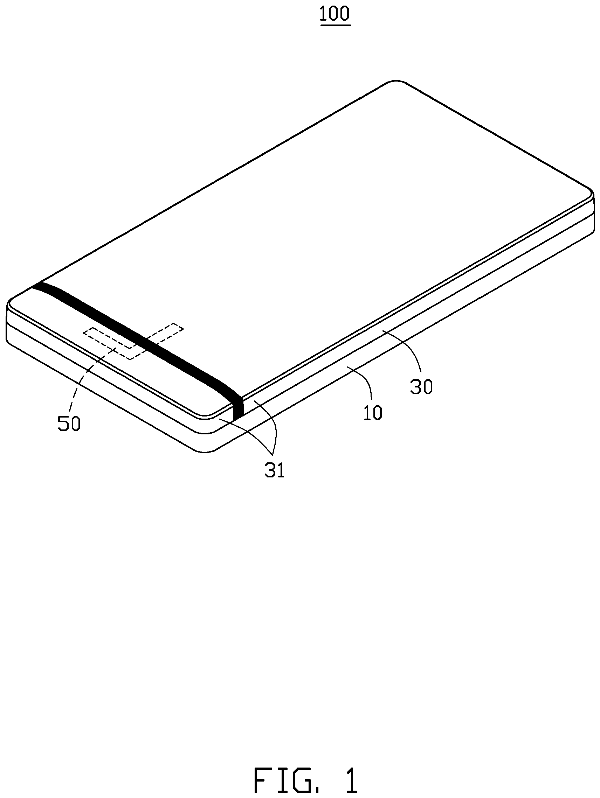

FIG. 1 illustrates an electronic device 100 according to an exemplary embodiment. The electronic device 100 can be, but not limited to, a mobile phone, a personal digital assistant or a panel computer. The electronic device 100 includes a main body 10, a housing 30 assembled to the main body 10, and an antenna 50 located inside the housing 30.

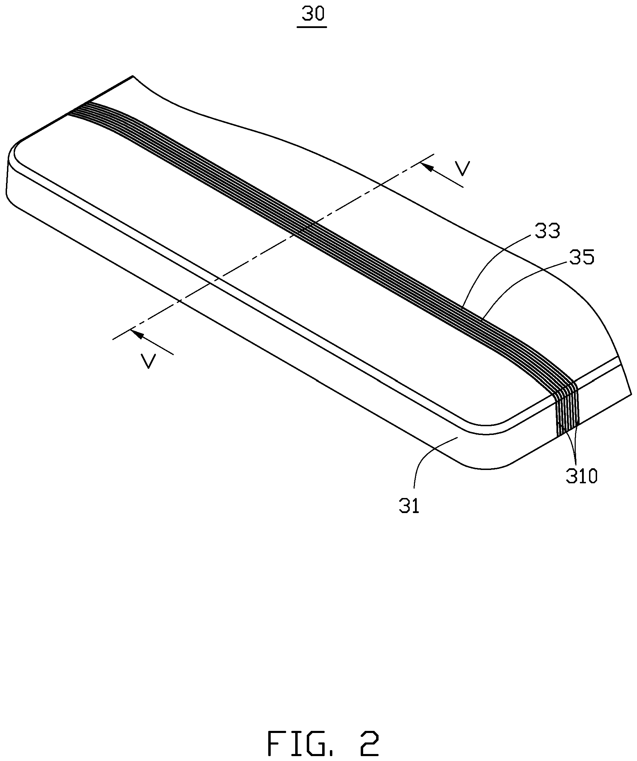

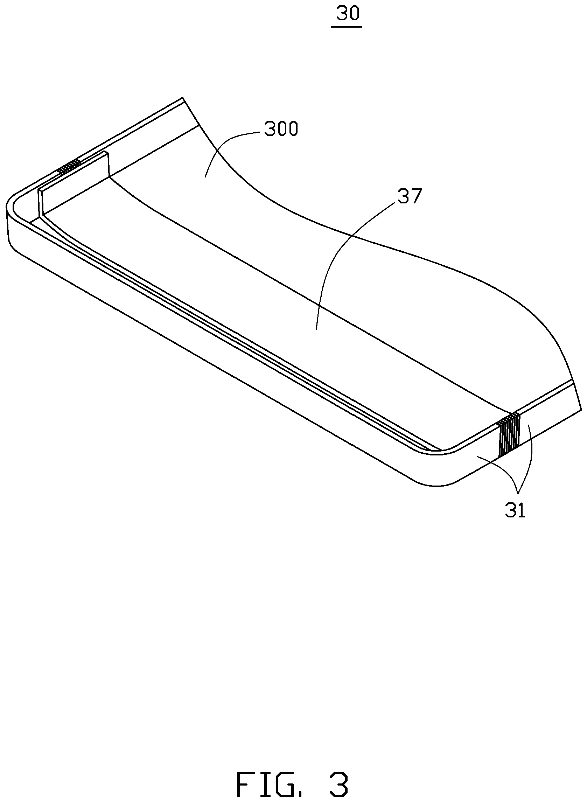

FIGS. 2 and 3 illustrate in one exemplary embodiment, the housing 30 can be a back cover of the electronic device 100. The housing 30 includes a base 31, at least one metal strip 33, at least two non-conductive members 35, and a combining layer 37 formed on the base 31. In this exemplary embodiment, the housing 30 includes a plurality of metal strips 33 and a plurality of non-conductive members 35. The base 31 further defines a receiving space 300 cooperating with main body 10 to receive internal elements of the electronic device 100, such as the antenna 50, battery (not shown) and so on.

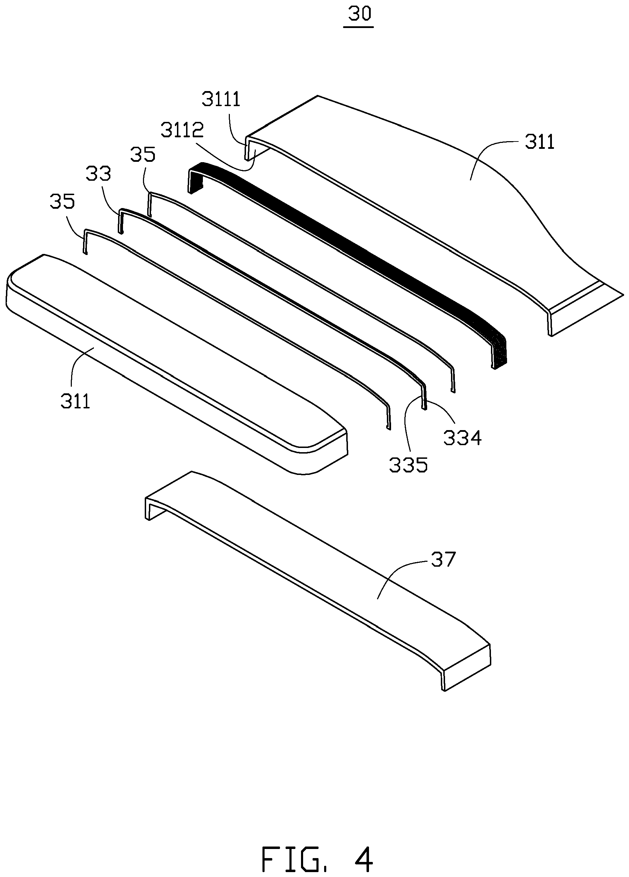

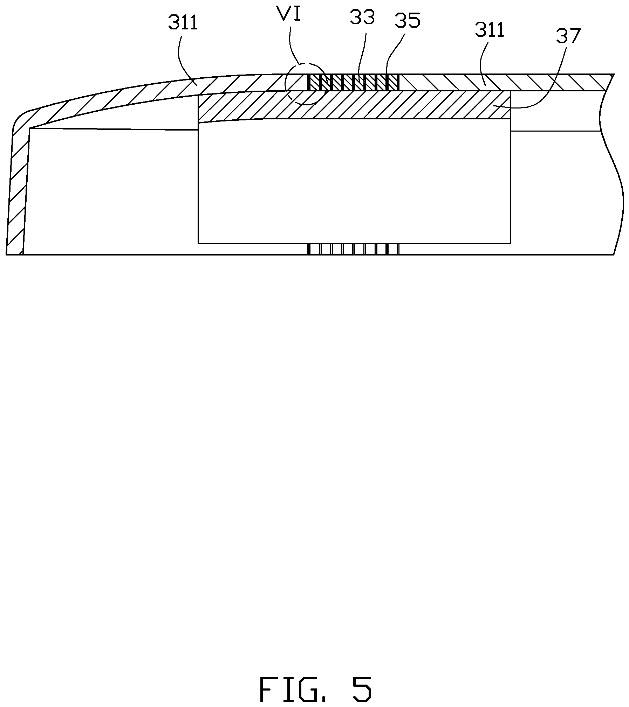

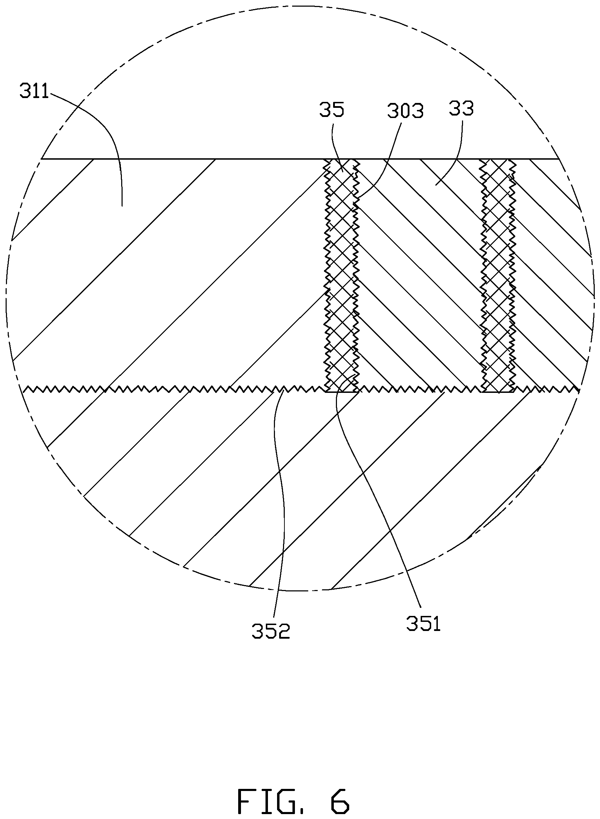

FIGS. 4 and 5 illustrate the base 31 is three-dimensional. In one exemplary embodiment, the base 31 has a substantially U-shaped cross-section. At least one opening 310 is defined in the base 31 corresponding the antenna 50 received in the receiving space 301 and running through an outer surface and an inner surface of the base 31. The at least one opening 310 divides the base 31 into at least two main portions 311. The at least two main portions 311 can be separated from each other or connected to each other through at least one portion of the base 31 adjacent to the openings 30. In one exemplary embodiment, the base 31 includes one opening 310 (shown in FIG. 6) dividing the base 31 into two separated main portions 311. The base 31 is made of metal. The metal can be selected from a group consisting of aluminum alloy, titanium alloy, magnesium alloy, and stainless steel.

The metal strips 33 and the non-conductive members 35 are received in the opening 310 and sandwiched between the two main portions 311. Each metal strip 33 alternates with one non-conductive member 35. Each two adjacent metal strips 33 are connected to each other by one non-conductive member 35 located between the two metal strips 33. A non-conductive member 35 is positioned between each main portion 310 and a metal strip 33 adjacent to the main portion 311, thereby combining the main portions 311 with the metal strips 33 adjacent to the main portions 311. Each main portion 311 is physically but not electrically connected (i.e. dielectrically connected) to the corresponding adjacent metal strips 33. Each metal strip 33 has a thickness of about 0.1 mm to about 1.0 mm along a direction from an adjacent non-conductive member 35 located at one side of the metal strip 33 to another adjacent non-conductive member 35 located at an opposite side of the metal strip 33. Each non-conductive member 35 has a thickness of about 20 µm to about 800µm along a direction from a metal strip 33 located at one sided of non-conductive member 35 to another adjacent metal strip 33 located at an opposite side of the non-conductive member 35, thereby creating a distance between each two adjacent metal strips 33 and a distance between each main portion 311 and the adjacent metal strip 33 both of about 20 µm to about 800µm. In other exemplary embodiments, the thickness of each non-conductive member 35 is about 150µm. Therefore, interference from the metal housing 30 to the antenna 50 can be reduced.

The metal strips 33 are substantially U-shaped corresponding to the main portions 311. Each non-conductive member 35 is adhered to adjacent metal strips 33. Each non-conductive member 35 is also substantially U-shaped to engage with the shape of the metal strips 33.

Each metal strip 33 is made of metal selected from a group consisting of aluminum alloy, titanium alloy, magnesium alloy, and stainless steel.

The non-conductive members 35 can be made of a plastic, glass, or other non-conductive materials. The plastic can be selected from one or more groups consisting of polyphenylene sulfide (PPS), polybutylene terephthalate (PBT), polyamide (PA), polyethylene terephthalate (PET), polytrimethylene terephthalate (PTT), polyetherimide (PEI), polyether ether ketone (PEEK), poly(ethylene-co-1,4-cyclohexylenedimethylene terephthalate) (PCT), and their modified materials.

Also referring to FIG. 4, an end portion of each main portion 311 includes a first side surface 3011 facing the metal strips 33 and a first inner surface 3112adjacent to the first side surface 3111. Each metal strip 33 includes two opposite second side surfaces 334 and a second inner surface 335 adjacent to the second side surfaces 334. FIG. 6 illustrates a plurality of holes 303 are defined in the first side surface 3111, the first inner surface 3112, the second side surface 334, and the second inner surface 335. The holes 303 can be micropores or nanopores. In this exemplary embodiment, a diameter of each hole 303 is about 15µm to about 800µm. In other embodiments, the diameter of each hole 303 can be about 20nm to about 400nm. Each non-conductive member 35 includes a plurality of ribs 351 proturding from a surface of the non-conductive member 35. The ribs 351 are configured to be embedded and fixed into the correponding holes 303.

The combining layer 37 is formed on the internal surface of the base 31 (i.e. a surface of the base 31 facing the main body 10). The combining layer 37 covers each metal strip 33, each non-conductive member 35, and entirely or partially covers an end portion of each main portion 311 connected to the non-conductive member 35. As such, the main portions 311, the metal strips 33, the non-conductive members 35, and the non-conductive member 35 are bonded together through the combining layer 37. The combining layer 37 can further enhance a bonding strength among the main portions 311, the metal strips 33, and the non-conductive members 35, respectively. The combining layer 37 is plastic material, and the plastic material can be selected one or more from a group consisting of polyphenylene sulfide (PPS), polybutylene terephthalate (PBT), polyamide (PA), polyethylene terephthalate (PET), polytrimethylene terephthalate (PTT), polyetherimide (PEI), polyether ether ketone (PEEK), poly(ethylene-co-1,4-cyclohexylenedimethylene terephthalate) (PCT), and their modified materials.

When the housing 30 is assembled to the main body 10, the assembly formed by the metal strips 33 and the non-conductive members 35 is corresponding to the antenna 50. The base 31 can be coupled with the antenna and serve as an extra antenna of the electronic device 100. In addition, signals of the antenna 50 can pass through the non-conductive members 35. Therefore, radiation efficiency of antenna 50 can be increased.

In another embodiment, the base 31 are not coupled with the antenna and does not serve as the extra antenna. The signals of the antenna 50 can pass through the non-conductive members 35 to increase the radiation efficiency of antenna 50.

An exemplary method for making the housing 30 can include the following steps.

The base 31 having three-dimensions is provided. The base 31 defines an opening 310 communicating through the base 31 and corresponding to the antenna 50. The opening 310 divides the base 31 into the two main portions 311. The main portions 311 are separated from each other or connected to each other through at least one portion of the base 31 adjacent to the openings 30. An end portion of each main portion 311 includes a first side surface 3111 facing another main portion 311 and a first inner surface 3112 adjacent to the first side surface 3111. The base 31 can be made by casting, punching, or computer numerical control. The base 31 is made of metal. The metal can be selected from a group consisting of aluminum alloy, titanium alloy, magnesium alloy, and stainless steel.

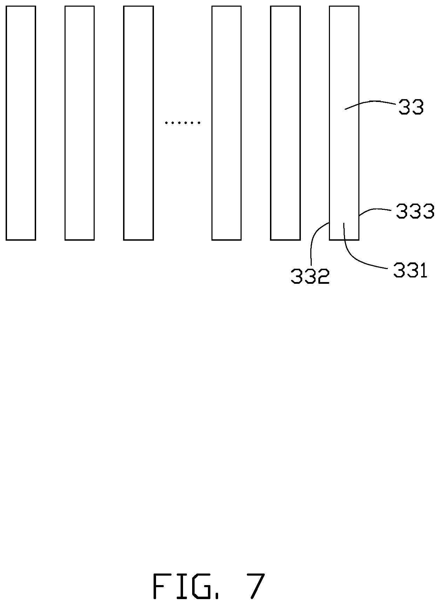

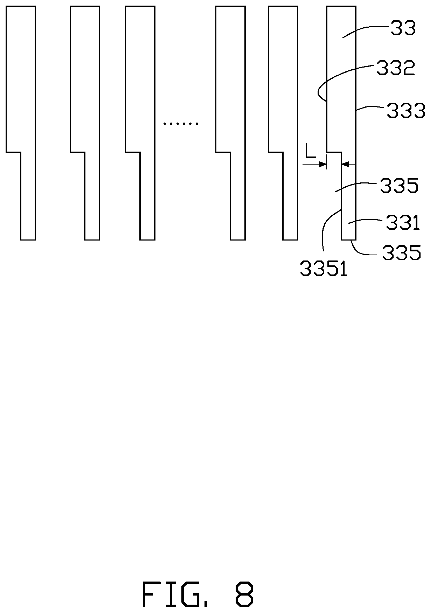

FIGS. 7, 8 and 9 illustrate at least one metal strip 33 or a plurality of metal strips 33 is provided. A notch 335 is defined in each metal strip 33. In one exemplary embodiment, each metal strip 33 includes a machined portion 331. The machined portion 331 is positioned at an end of each metal strip 33. The machined portion 331 includes a first surface 332, a second surface 333, and an inner surface 335 adjacent to the first and second surfaces 332, 333. The first surface 332 of each metal strip 33 is milled to form a notch 335 (shown in FIG. 8). In this exemplary embodiment, the notch 335 is substantially a rectangular cutoff positioned at a corner of said metal strip 33. Each metal strip 33 includes a bottom wall 3351 at the notch 335 opposite to the second surface 333. A width L of the notch 335 along a direction from the first surface 332 to the second surface 333 is about 20µm to about 800µm. In one exemplary embodiment, the width L of the notch 335 is 150µm. A distance between the bottom 3351 and the second surface 333 is about 0.1mm to about 1.0mm. The metal strips 33 are made of metal selected from a group consisting of aluminum alloy, titanium alloy, magnesium alloy, and stainless steel.

A plurality of holes is defined in the first side surface 3111, the first inner surface 302, each surface of the machined portion 331. In this exemplary embodiment, the plurality of holes are formed on the first side surface 3111, the first inner surface 302, and each surface of the machined portion 331 by solution impregnation, electrochemical etching, chemical etching or anodic oxidation. The holes 303 can be micropores or nanopores. In this exemplary embodiment, a diameter of each hole 303 is about 15µm to about 800µm. In other embodiments, the diameter of each hole 303 can be about 20nm to about 400nm.

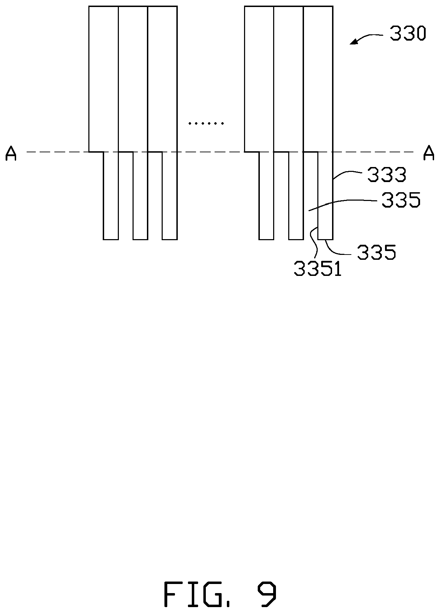

FIG. 9 illustrate the metal strips 33 are joined together to form a metal strip assembly 330 with the notch 335 of each metal strip 33 positioned at a same end. The joined metal strip assembly 330 is inserted into the opening 310. An end of each metal strip 33 has the notch 335 facing the inner surface of the base 31. A plurality of non-conductive members 35 are formed by injection molding.

In this exemplary embodiment, the base 31 is placed in a mold for forming (not shown). The jointed metal strip assembly 330 is inserted into the opening 310. A plurality of gaps (not shown) is defined between the metal strip assembly 330 and the main portions 311. The notches 335 are positioned between the metal strips 33 facing the inner surface of the base 31. Liquid molten plastic is injected into the forming mold. The Liquid molten plastic is filled into the notches 335 and the gaps between each main portion 311 and the metal strip assembly 330, and also covers the first inner surface 3112 of each main portion 311 and each second inner surface 335 of each metal strip 33. After cooling, the plastic is solidified to form a plurality of non-conductive members 35 filled in the notches 33 and the gaps between each main portion 311 and the metal strip assembly 330, and also forms a combing layer 37 covering each metal strip 33, each non-conductive member 35, and entirely or partially covering an end portion of each main portion 311 connected to the non-conductive member 35. The combining layer 37 can further enhance a bonding strength among the main portions 311, the metal strips 33, and the non-conductive members 35, respectively.

A redundant portion of each metal strip 33 exposed from the outer surface of the base 31 can be removed by numerical control machines. For example, the redundant portion of each metal strip 33 at least includes a portion of each metal strip 33 positioned above a broken line A-A as shown in FIG. 9 (i.e. a portion of each metal strip 33 except for the machined portion 331). As such, the metal strips 33 and the base 31 can obtain a smooth appearance to from the housing 30. Finally, the housing 30 can be polished or decorated.

In other embodiments, the combining layer 37 can be formed by a secondary injection molding. That is, the non-conductive members 35 are formed by a first injection molding, and the combining layer 37 is formed by a second injection molding.

In addition, while injecting the plastics into the mold, the non-conductive members 35 are also embedded into the holes 303 of the main portions 311 and the metal strips 33 to form a plurality of ribs 351, 352.

The housing 30 forms the plurality of metal strips 33 and the plurality of non-conductive members 35 corresponding to the antenna 50 to reduce interference from the housing 30 to the antenna 50. In addition, the base 31 can be coupled with the antenna 50 to serve as an extra antenna of the electronic device 100 to increase the radiation efficiency of the antenna 50. The non-conductive members 35 partially embedded into the holes 303 are defined in each main portion 311 and each metal strip and the combining layer 37 formed on the inner surface of the base 31 enhance the bonding strength among the main portion 311, the metal strips 35, and the non-conductive members 35, respectively.

It is to be understood, however, that even through numerous characteristics and advantages of the present disclosure have been set forth in the foregoing description, together with details of assembly and function, the disclosure is illustrative only, and changes may be made in detail, especially in the matters of shape, size, and arrangement of parts within the principles of the disclosure to the full extent indicated by the broad general meaning of the terms in which the appended claims are expressed.

## Claims

1. A housing (30) for an electronic device, the housing comprising a base (31) made of metal, the base (31) defining at least two openings (301) corresponding to an antenna of the electronic device, the at least two openings (310) dividing the base (31) into at least two main portions (311), the at least two main portions (311) separated from each other through at least one portion of the base (31) adjacent to the at least two openings (310), each of the at least two openings (310) having at least one metal strip (33), each metal strip (33) alternating with one non-conductive member (35), each two adjacent metal strips (33) connected to each other by one non-conductive member (35) located between the two metal strips (33), one non-conductive member (35) positioned between each main portion (311) and one metal strip (33) adjacent to the main portion (311), thereby combining the main portions (311) with the at least one metal strips (33) adjacent to the main portions (311); wherein the housing (30) further comprises a combining layer (37) of plastic material, the combining layer (37) is formed on an internal surface of the base (31) and entirely covers each metal strip (33), each non-conductive member (35), and one end of each main portion (311) connected to the non-conductive member (35).

2. The housing (30) as claimed in claim 1, wherein the metal strips (33) and the main portions (311) are dielectrically connected by the non-conductive members (35).

3. The housing (30) as claimed in claim 1, wherein the at least two main portions (311) are separated from each other or connected to each other through at least one portion of the base (31) adjacent to the openings (310).

4. The housing (30) as claimed in claim 1, wherein each surface of each metal strip (33) attached to the non-conductive members (35) defines a plurality of holes (303) by solution impregnation, electrochemical etching, chemical etching or anodic oxidation, each surface of each non-conductive member (35) attached to the metal strips (33) comprises a plurality of ribs (351) formed by liquid molten plastic, the ribs (351) are embedded and fixed into the holes (303).

5. The housing (30) as claimed in claim 1, wherein a surface of each non-conductive member (35) attached to each main portion (311) comprises a plurality of ribs (351) formed by liquid molten plastic, a side surface of each main portion (311) defines a plurality of holes (303) by solution impregnation, electrochemical etching, chemical etching or anodic oxidation, the ribs (351) are embedded and fixed into the holes (303).

6. The housing (30) as claimed in claim 1, wherein each metal strip (33) has a thickness of about 0.1 mm to about 1.0 mm along a direction from an adjacent non-conductive member (33) located at one side of the metal strip (33) to another adjacent non-conductive member (35) located at an opposite side of the metal strip (33).

7. The housing (30) as claimed in claim 1, wherein each non-conductive member (35) has a thickness of about 20 µm to about 800µm along a direction from a metal strip (33) located at one side of non-conductive member (35) to another adjacent metal strip located at an opposite side of the non-conductive member (35), the non-conductive members (35) are made of plastic selected one or more from a group consisting of polyphenylene sulfide, polybutylene terephthalate, polyamidepolyamide, polyethylene terephthalate, polytrimethylene terephthalate, polyetherimide, polyether ether ketone, poly(ethylene-co-1,4-cyclohexylenedimethylene terephthalate), and their modified materials.

8. The housing (30) as claimed in claim 1, wherein each metal strip (33) and each main portion (311) both comprises an inner surface defining a plurality of holes (303) by solution impregnation, electrochemical etching, chemical etching or anodic oxidation, an inner surface of the combining layer (37) covering the metal strips (33) and the main portions (311) comprises a plurality of ribs (351) formed by liquid molten plastic, the ribs (351) are embedded and fixed into the holes (303).

9. A method of making a housing (30) for an electronic device comprising an antenna, the method comprising providing a base (31) made of metal and defining a plurality of openings (310), the plurality of openings dividing the base (31) into at least two main portions (311); providing a plurality of metal strips (33), each end of each metal strip (33) defining a notch (335), jointing the metal strips (33) together to form a metal strip assembly (330) with each end having the notch (335) positioned at a same end, inserting the metal strip assembly into one of the openings (310) with the notches (335) facing an inner surface of the base (31); placing the base (31) and the metal strip assembly (330) in a mold; injecting liquid molten plastics into the mold so that the plastic is filled into the notches (335); wherein after cooling, the plastic is solidified to form a plurality of non-conductive members (35) filled in the notches (335) and the gaps between each main portion (311) and the metal strip assembly (330), and also forms a combining layer (37) entirely covering each metal strip (33), each non-conductive member (35), and one end portion of each main portion (311) connected to the non-conductive member (35); and
removing a redundant portion of each metal strip (33) exposed from the outer surface of the base (31) by numerical control machines.

10. The method as claimed in claim 9, wherein the at least two main portions (311) are separated from each other or connected to each other through at least one portion of the base (31) adjacent to the openings (310).

11. The method as claimed in claim 9, wherein each main portion (311) comprises a side surface (3111) and an inner surface (3112) adjacent to the side surface (3111), the side surface (3111), the inner surface (3112) of each main portion (311), and the end of each metal strip (33) having the notch (335) define a plurality of holes (303) by solution impregnation, electrochemical etching, chemical etching or anodic oxidation, before the step of injection molding.

12. The method as claimed in claim 9, wherein in the step of injection molding, a portion of the plastics are filled into the holes (303) to form a plurality of ribs (351).

13. An electronic device (100) comprising a main body (10), a housing (30) according to any one of claim 1 to 8, and an antenna (50), the housing (30) mounted on the main body (10) and the antenna (50) assembled in the housing (30).

## Patentansprüche

1. Gehäuse (30) für eine elektronische Vorrichtung, wobei das Gehäuse eine Basis (31), hergestellt aus Metall, umfasst, wobei die Basis (31) zumindest zwei Öffnungen (301) definiert, welche einer Antenne der elektronischen Vorrichtung entsprechen, wobei die zumindest zwei Öffnungen (310) die Basis (31) in zumindest zwei Hauptabschnitte (311) unterteilen, wobei die zumindest zwei Hauptabschnitte (311) durch zumindest einen Abschnitt der Basis (31), welcher zu den zumindest zwei Öffnungen (310) benachbart ist, voneinander getrennt sind, wobei jede von den zumindest zwei Öffnungen (310) zumindest einen Metallstreifen (33) aufweist, wobei jeder Metallstreifen (33) mit einem nicht leitenden Element (35) abwechselt, wobei jeweils die zwei benachbarte Metallstreifen (33) mittels eines nicht leitenden Elements (35), welches sich zwischen den zwei Metallstreifen (33) befindet, miteinander verbunden sind, wobei ein nicht leitendes Element (35) zwischen jedem Hauptabschnitt (311) und einem zu dem Hauptabschnitt (311) benachbarten Metallstreifen (33) positioniert ist, wodurch die Hauptabschnitte (311) mit dem zumindest einem zu den Hauptabschnitten (311) benachbarten Metallstreifen (33) kombiniert werden;
wobei das Gehäuse (30) weiter eine Kombinationsschicht (37) aus Kunststoffmaterial umfasst, die Kombinationsschicht (37) auf einer internen Oberfläche der Basis (31) gebildet wird und jeden Metallstreifen (33), jedes nicht leitende Element (35) und ein Ende von jedem Hauptabschnitt (311), welches mit dem nicht leitenden Element (35) verbunden ist, vollständig bedeckt.

2. Gehäuse (30) nach Anspruch 1, wobei die Metallstreifen (33) und die Hauptabschnitte (311) mittels der nicht leitenden Elemente (35) dielektrisch verbunden sind.

3. Gehäuse (30) nach Anspruch 1, wobei die zumindest zwei Hauptabschnitte (311) durch zumindest einen Abschnitt der Basis (31), welcher zu den Öffnungen (310) benachbart ist, voneinander getrennt oder miteinander verbunden sind.

4. Gehäuse (30) nach Anspruch 1, wobei jede Oberfläche von jedem Metallstreifen (33), welcher an den nicht leitenden Elementen (35) befestigt ist, eine Vielzahl von Löchern (303) mittels Lösungsimprägnierung, elektrochemischen Ätzens , chemischen Ätzens oder anodischer Oxidation definiert, jede Oberfläche von jedem nicht leitenden Element (35), welches an den Metallstreifen (33) befestigt ist, eine Vielzahl von Rippen (351) umfasst, welche durch flüssigen, geschmolzenen Kunststoff gebildet werden, die Rippen (351) in die Löcher (303) eingebettet und darin befestigt sind.

5. Gehäuse (30) nach Anspruch 1, wobei eine Oberfläche von jedem nicht leitendem Element (35), welches an jedem Hauptabschnitt (311) befestigt ist, eine Vielzahl von Rippen (351) umfasst, welche durch flüssigen, geschmolzenen Kunststoff gebildet werden, eine Seitenoberfläche von jedem Hauptabschnitt (311) eine Vielzahl von Löchern (303) mittels Lösungsimprägnierung, elektrochemischen Ätzens, chemischen Ätzens oder anodischer Oxidation definiert, die Rippen (351) in die Löcher (303) eingebettet und darin befestigt sind.

6. Gehäuse (30) nach Anspruch 1, wobei jeder Metallstreifen (33) eine Dicke von etwa 0,1 mm bis etwa 1,0 mm entlang einer Richtung von einem benachbarten nicht leitenden Element (33), welches sich an einer Seite des Metallstreifens (33) befindet, zu einem weiteren benachbarten nicht leitenden Element (35), welches sind an einer gegenüberliegenden Seite des Metallstreifens (33) befindet, aufweist.

7. Gehäuse (30) nach Anspruch 1, wobei jedes nicht leitende Element (35) eine Dicke von etwa 20 µm bis etwa 800 µm entlang einer Richtung von einem Metallstreifen (33), welcher sich an einer Seite des nicht leitenden Elements (35) befindet, zu einem weiteren benachbarten Metallstreifen, welcher sind an einer gegenüberliegenden Seite des nicht leitenden Elements (35) befindet, aufweist, die nicht leitenden Elemente (35) aus Kunststoff herstellt sind, ausgewählt eines oder mehrere von einer Gruppe, bestehend aus Polyphenylensulfid, Polybutylenterephthalat, Polyaminopolyamid, Polyethylenterephthalat, Polytrimethylenterephthalat, Polyetherimid, Polyetheretherketon, Poly(ethylen-co-1,4-cyclohexylendimethylenterephthalat) und ihren modifizierten Materialien.

8. Gehäuse (30) nach Anspruch 1, wobei jeder Metallstreifen (33) und jeder Hauptabschnitt (311) jeweils eine innere Oberfläche umfassen, welche eine Vielzahl von Löchern (303) mittels Lösungsimprägnierung, elektrochemischen Ätzens, chemischen Ätzens oder anodischer Oxidation definiert, eine innere Oberfläche der Kombinationsschicht (37), welche die Metallstreifen (33) und die Hauptabschnitte (311) bedeckt, eine Vielzahl von Rippen (351) umfasst, welche durch flüssigen, geschmolzenen Kunststoff gebildet werden, die Rippen (351) in die Löcher (303) eingebettet und darin befestigt sind.

9. Verfahren zum Herstellen eines Gehäuses (30) für eine elektronische Vorrichtung, umfassend eine Antenne, wobei das Verfahren das Bereitstellen einer Basis (31) umfasst, welche aus Metall hergestellt ist und eine Vielzahl von Öffnungen (310) definiert, wobei die Vielzahl von Öffnungen die Basis (31) in zumindest zwei Hauptabschnitte (311) unterteilt;
Bereitstellen von einer Vielzahl von Metallstreifen (33), wobei jedes Ende jedes Metallstreifens (33) eine Kerbe (335) definiert, die Metallstreifen (33) zusammenfügt, um eine Metallstreifenbaugruppe (330) zu bilden, wobei jedes Ende die Kerbe (335) an demselben Ende positioniert hat, die Metallstreifenbaugruppe in eine von den Öffnungen (310) einfügt, wobei die Kerben (335) auf eine innere Oberfläche der Basis (31) gerichtet sind;
Platzieren der Basis (31) und der Metallstreifenbaugruppe (330) in einer Form; Einspritzen von flüssigem, geschmolzenem Kunststoff in die Form, sodass der Kunststoff in die Kerben (335) gefüllt wird;
wobei nach dem Kühlen der Kunststoff verfestigt wird, um eine Vielzahl von nicht leitenden Elementen (35) zu bilden, welche in die Kerben (335) und die Spalten zwischen jedem Hauptabschnitt (311) und der Metallstreifenbaugruppe (330) gefüllt sind, und auch eine Kombinationsschicht (37) bildet, welche jeden Metallstreifen (33), jedes nicht leitende Element (35) und einen Endabschnitt von jedem Hauptabschnitt (311), welcher mit dem nicht leitenden Element (35) verbunden ist, vollständig bedeckt; und
Entfernen eines überflüssigen Abschnitts von jedem Metallstreifen (33), welcher über die äußere Oberfläche der Basis (31) herausragt, mittels numerischer Steuerungsmaschinen.

10. Verfahren nach Anspruch 9, wobei die zumindest zwei Hauptabschnitte (311) durch zumindest einen Abschnitt der Basis (31), welcher zu den Öffnungen (310) benachbart ist, voneinander getrennt oder miteinander verbunden sind.

11. Verfahren nach Anspruch 9, wobei jeder Hauptabschnitt (311) eine Seitenoberfläche (3111) und eine innere Oberfläche (3112), welche benachbart zu der Seitenoberfläche (3111) ist, umfasst, wobei die Seitenoberfläche (3111), die innere Oberfläche (3112) von jedem Hauptabschnitt (311) und das Ende von jedem Metallstreifen (33) vor dem Schritt des Spritzgießens die Kerbe (335) eine Vielzahl von Löchern (303) mittels Lösungsimprägnierung, elektrochemischen Ätzens, chemischen Ätzens oder anodischer Oxidation definieren lassen.

12. Verfahren nach Anspruch 9, wobei in dem Schritt des Spritzgießens ein Abschnitt der Kunststoffe in die Löcher (303) gefüllt wird, um eine Vielzahl von Rippen (351) zu bilden.

13. Elektronische Vorrichtung (100), umfassend einen Hauptkorpus (10), ein Gehäuse (30) nach einem der Ansprüche 1 bis 8 und eine Antenne (50), wobei das Gehäuse (30) auf dem Hauptkorpus (10) montiert ist und die Antenne (50) in dem Gehäuse (30) zusammengebaut ist.

## Revendications

1. Boîtier (30) pour un dispositif électronique, le boîtier comprenant une base (31) faite de métal, la base (31) définissant au moins deux ouvertures (301) correspondant à une antenne du dispositif électronique, les au moins deux ouvertures (310) divisant la base (31) en au moins deux parties principales (311), les au moins deux parties principales (311) étant séparées l'une de l'autre par au moins une partie de la base (31) adjacente aux au moins deux ouvertures (310), chacune des au moins deux ouvertures (310) ayant au moins une bande métallique (33), chaque bande métallique (33) alternant avec un élément non conducteur (35), chacune des deux bandes métalliques adjacentes (33) étant connectée l'une à l'autre par un élément non conducteur (35) situé entre les deux bandes métalliques (33), un élément non conducteur (35) étant positionné entre chaque partie principale (311) et une bande métallique (33) adjacente à la partie principale (311), combinant ainsi les parties principales (311) avec la au moins une bande métallique (33) adjacente aux parties principales (311) ;
dans lequel le boîtier (30) comprend en outre une couche de combinaison (37) en matériau plastique, la couche de combinaison (37) est formée sur une surface interne de la base (31) et recouvre entièrement chaque bande métallique (33), chaque élément non conducteur (35) et une extrémité de chaque partie principale (311) connectée à l'élément non conducteur (35).

2. Boîtier (30) selon la revendication 1, dans lequel les bandes métalliques (33) et les parties principales (311) sont connectées diélectriquement par les éléments non conducteurs (35).

3. Boîtier (30) selon la revendication 1, dans lequel les au moins deux parties principales (311) sont séparées l'une de l'autre ou connectées l'une à l'autre par au moins une partie de la base (31) adjacente aux ouvertures (310).

4. Boîtier (30) selon la revendication 1, dans lequel chaque surface de chaque bande métallique (33) fixée aux éléments non conducteurs (35) définit une pluralité de trous (303) par imprégnation de solution, gravure électrochimique, gravure chimique ou oxydation anodique, chaque surface de chaque élément non conducteur (35) fixé aux bandes métalliques (33) comprend une pluralité de nervures (351) formées par du plastique fondu liquide, les nervures (351) sont imbriquées et fixées dans les trous (303).

5. Boîtier (30) selon la revendication 1, dans lequel une surface de chaque élément non conducteur (35) fixée à chaque partie principale (311) comprend une pluralité de nervures (351) formées par du plastique fondu liquide, une surface latérale de chaque partie principale (311) définit une pluralité de trous (303) par imprégnation de solution, gravure électrochimique, gravure chimique ou oxydation anodique, les nervures (351) sont imbriquées et fixées dans les trous (303).

6. Boîtier (30) selon la revendication 1, dans lequel chaque bande métallique (33) a une épaisseur d'environ 0,1 mm à environ 1,0 mm le long d'une direction d'un élément non conducteur adjacent (33) situé sur un côté de la bande métallique (33) à un autre élément non conducteur adjacent (35) situé sur un côté opposé de la bande métallique (33).

7. Boîtier (30) selon la revendication 1, dans lequel chaque élément non conducteur (35) a une épaisseur d'environ 20µm à environ 800 µm le long d'une direction d'une bande métallique (33) située sur un côté d'un élément non conducteur (35) à une autre bande métallique adjacente située sur un côté opposé de l'élément non conducteur (35), les éléments non conducteurs (35) sont faits d'un plastique un ou plusieurs sélectionné à partir d'un groupe constitué par le sulfure de polyphénylène, le térephthalate de polybutylène, le polyamidepolyamide, le térephthalate de polyéthylène, le térephthalate de polytriméthylène, le polyéthérimide, le polyéther-éther-cétone, le térephthalate de poly(éthylène-co-1,4-cyclohexylènediméthylène), et leurs matériaux modifiés.

8. Boîtier (30) selon la revendication 1, dans lequel chaque bande métallique (33) et chaque partie principale (311) comprennent une surface interne définissant une pluralité de trous (303) par imprégnation de solution, gravure électrochimique, gravure chimique ou oxydation anodique, une surface interne de la couche de combinaison (37) recouvrant les bandes métalliques (33) et les parties principales (311) comprend une pluralité de nervures (351) formées par du plastique fondu liquide, les nervures (351) sont imbriquées et fixées dans les trous (303).

9. Procédé de fabrication d'un boîtier (30) pour un dispositif électronique comprenant une antenne, le procédé comprenant la fourniture d'une base (31) faite de métal et définissant une pluralité d'ouvertures (310), la pluralité d'ouvertures divisant la base (31) en au moins deux parties principales (311) ;
la fourniture d'une pluralité de bandes métalliques (33), chaque extrémité de chaque bande métallique (33) définissant une encoche (335), assemblant les bandes métalliques (33) ensemble pour former un ensemble bande métallique (330) avec chaque extrémité ayant l'encoche (335) positionnée à une même extrémité, insérant l'ensemble bande métallique dans une des ouvertures (310) avec les encoches (335) faisant face à une surface interne de la base (31) ;
le placement de la base (31) et de l'ensemble bande métallique (330) dans un moule; l'injection de plastique fondu liquide dans le moule pour que le plastique soit introduit dans les encoches (335) ;
dans lequel après le refroidissement, le plastique est solidifié pour former une pluralité d'éléments non conducteurs (35) introduits dans les encoches (335) et les espaces entre chaque partie principale (311) et l'ensemble bande métallique (330), et forme également une couche de combinaison (37) recouvrant entièrement chaque bande métallique (33), chaque élément non conducteur (35), et une partie extrémité de chaque partie principale (311) connectée à l'élément non conducteur (35) ; et
le retrait d'une partie redondante de chaque bande métallique (33) exposée depuis la surface externe de la base (31) par des machines à commande numérique.

10. Procédé selon la revendication 9, dans lequel
les au moins deux parties principales (311) sont séparées l'une de l'autre ou connectées l'une à l'autre par au moins une partie de la base (31) adjacente aux ouvertures (310).

11. Procédé selon la revendication 9, dans lequel chaque partie principale (311) comprend une surface latérale (3111) et une surface interne (3112) adjacente à la surface latérale (3111), la surface latérale (3111), la surface interne (3112) de chaque partie principale (311), et l'extrémité de chaque bande métallique (33) ayant l'encoche (335) définissent une pluralité de trous (303) par imprégnation de solution, gravure électrochimique, gravure chimique ou oxydation anodique, avant l'étape de moulage par injection.

12. Procédé selon la revendication 9, dans lequel à l'étape de moulage par injection, une partie du plastique est introduite dans les trous (303) pour former une pluralité de nervures (351).

13. Dispositif électronique (100) comprenant un corps principal (10), un boîtier (30) selon l'une quelconque des revendications 1 à 8, et une antenne (50), le boîtier (30) monté sur le corps principal (10) et l'antenne (50) assemblée dans le boîtier (30).
